Europäisches Patentamt

European Patent Office

Office européen des brevets

(11) Publication number: **0 066 990**
**B1**

(12) **EUROPEAN PATENT SPECIFICATION**

(45) Date of publication of patent specification: **05.03.86**

(21) Application number: **82302586.1**

(22) Date of filing: **20.05.82**

(51) Int. Cl.⁴: **G 03 F 7/02, G 03 C 5/34,
G 03 D 5/04**

(54) **Process for production of presensitized lithographic printing plates.**

(30) Priority: **20.05.81 JP 77017/81**

(43) Date of publication of application:
**15.12.82 Bulletin 82/50**

(45) Publication of the grant of the patent:
**05.03.86 Bulletin 86/10**

(84) Designated Contracting States:
**DE GB**

(56) References cited:

**None**

(73) Proprietor: **KONISHIROKU PHOTO INDUSTRY
CO. LTD.
No. 1 Sakura-machi
Hino-shi Tokyo (JP)**

(72) Inventor: **Seino, Minoru
2488-8 Nakano-machi
Hachioji-shi Tokyo (JP)**
Inventor: **Suzuki, Akihiko
6-5-2 Tamadaira
Hino-shi Tokyo (JP)**
Inventor: **Aoki, Toru
5-303 Kashiwa-cho Danchi 4-51-1 Kashiwa-cho
Tachikawa-shi Tokyo (JP)**

(74) Representative: **Ellis-Jones, Patrick George
Armine et al
J.A. KEMP & CO. 14 South Square Gray's Inn
London WC1R 5EU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a method of processing an exposed photosensitive lithographic printing plate as claimed in Claim 1 and particularly to an improvement in processing subsequent to development.

Generally, the process of a photosensitive lithographic printing plate (abbreviated to P.S. plate) may be carried out by a process which comprises performing, in order, a stop treatment for stopping the development and for removing the development liquid and the dissolved components, attached to the printing plate, and a desensitizing treatment to impart hydrophilicity to the non-image area to protect the non-image area of the printing plate until a printing process is carried out, or by a process wherein the stop treatment takes place concurrently with the desensitizing treatment after imagewise exposure and development of the P.S. plate.

The above-mentioned process wherein the stop treatment and the desensitizing treatment are sequentially performed has been applied to P.S. plate processing in which a P.S. plate containing, as the sensitizing component, a diazo compound or an o-quinonediazide compound is developed with an alkaline developer, but this requires not only the use and discharge of a large quantity of water as processing solution for the stop treatment but is disadvantageous economically because of the necessity of taking measures against environmental pollution; to cope with this, a process for performing concurrently the stop treatment with the desensitizing treatment has recently been developed, as disclosed in, e.g., Japanese Patent Publication Open to Public Inspection (hereinafter referred to as Japanese Patent O.P.I. Publication) No. 8002/1979. Those P.S. plates which contain, as the photosensitive component a photopolymerizable or photocrosslinkable component are generally subjected to the stop treatment concurrently with the desensitizing treatment. However, these methods, although they have the advantage that, in processing a large number of P.S. plates, since the respective processing liquids are generally used cyclically, it is not necessary to use a large quantity of solution for the stop treatment (generally water), have been found still to have the following disadvantages:

1. When processing a large number of P.S. plates, the processing liquid must be replaced frequently, for example each time when processing 20—30 m² of P.S. plate/litre, which is of course inefficient.

2. As the time for replacing the liquid approaches the so-called scomming phenomenon (due to the gradual occurrence of ink receptivity in the non-image area) occurs, so that it is difficult to maintain the quality.

3. The processing liquid containing the oleophilic component (oily substance) must be discarded, although this is undesirable from the pollution point of view.

Accordingly, it is an object of the present invention to provide a method of processing an exposed photosensitive lithographic printing plate which gives rise to little or no waste processing liquid following development while avoiding scomming of the plates.

We have found, according to the present invention, that the above objects can be accomplished by a method of processing an exposed photosensitive lithographic printing plate which comprises the step of processing in at least one wet process step after developing said exposed photosensitive lithographic printing plate, the processing liquid used in said at least one wet process step being used in circulation, the amount of processing liquid in a preceding step carried into said processing liquid used in circulation is smaller than that of said processing liquid used in circulation to be carried out therefrom, and the shortage of said processing liquid is replenished by a replenisher.

The method of the present invention is illustrated in further detail below:

The P.S. plate to be used in the present invention can be a conventional P.S. plate which has a support having thereon a photosensitive layer comprising a photosensitive material.

The said support for the P.S. plate to be used in the present invention may be, for example, paper, plastic-laminated paper, metallic plates such as aluminium, zinc and copper, plastic film such as of polyethylene terephthalate, polypropylene or cellulose triacetate, and metals, paper or plastic film vacuum-deposited or laminated with, say, chromium or nickel. Among these support materials, aluminium plates are preferably used because they possess excellent dimensional stability and are economical.

The surface of these supports is preferably treated to render the surface hydrophilic, to prevent a possible detrimental reaction with a photosensitive composition to be provided, as a layer, on the support and to improve the adhesiveness of the support to the photosensitive layer. For example, an aluminium plate, after mechanical, chemical and/or electrical graining, should be subjected to a treatment involving immersing it into hot water or an aqueous solution of, for example, sodium silicate, potassium fluorozirconate or phosphate and/or to an anodically oxidizing treatment.

The sensitive material of the P.S. plate to be used in the present invention includes, e.g., diazo compounds, o-quinonediazide compounds, photocrosslinkable compounds and photopolymerizable compounds.

The above-mentioned diazo compounds may be typified by diazonium salts and a diazo resin which is a condensate of p-diazodiphenylamine with formaldehyde; the p-diazodiphenylamine phenolates or fluorocaprates as described in Japanese Patent Examined Publication No. 7364/1977; the diazo resin compound consisting of an organic solvent-soluble salt of a paraformaldehyde condensate of 3-methoxy-diphenylamine-4-diazonium chloride and 4-nitrodiphenylamine as described in Japanese

2

Patent Examined Publication No. 48001/1974; and the 2-methoxy-4-hydroxy-5-benzoyl benzene sulphonate of the condensate of p-diazodiphenylamine with formaldehyde.

Among these condensates, the hexafluorophosphate of the condensates of p-diazodiphenylamine with formaldehyde is most suitable. .

Among the above-mentioned o-quinonediazide compounds, those particularly preferred are o-naphthoquinone diazide compounds which are described in, e.g. U.S. Patent Nos. 3,046,110, 3,046,111, 3,046,121, 3,046,115, 3,046,118, 3,046,119, 3,046,120, 3,046,122, 3,046,123, 3,061,430, 3,102,809, 3,106,465, 3,635,707 and 3,647,443.

Among the compounds exemplified in these publications, the esters of aromatic hydroxy compounds with o-naphthoquinonediazide sulphonic acid or o-naphthoquinonediazide carboxylic acid esters and the amides of aromatic amino compounds with o-naphthoquinonediazide sulphonic acid or o-naphthoquinonediazide carboxylic acid are preferred, and, particularly, the ester of 1,2-diazobenzoquinone sulphonic acid and polyhydroxyphenyl or the ester of 1,2-diazonaphthoquinone sulphonic acid and resorcinol-benzaldehyde resin as described in Japanese Patent O.P.I. Publication No. 1044/1981 are preferred.

Suitable photocrosslinkable materials include those compounds described in U.S. Patent No. 3,860,426, and suitable photopolymerizable materials include the photopolymers described in U.S. Patent Nos. 4,072,528 and 4,072,527.

For the formation of a photosensitive layer containing these photosensitive materials, a resin is preferably used as a carrier for the purpose of improving the physical properties of the layer.

Suitable resins used as a carrier, when incorporating a diazo compound as a photosensitive material, include shellac, polyvinyl alcohol derivatives, and copolymers having on a side chain an alcoholic hydroxyl group, as described in Japanese Patent O.P.I. Publication No. 118802/1975, and copolymers having a side chain phenolic hydroxy group, as described in Japanese Patent O.P.I. Publication No. 155355/1980, are particularly preferred.

For the incorporation of an o-quinonediazide compound as a photosensitive material, there may be used a carrier resin such as an alkali-soluble novolak resin e.g. a phenol-formaldehyde resin, cresol-formaldehyde resin, p-tert-butyl phenol resin or phenol-modified xylene resin.

The photosensitive layer in the P.S. plate used in the present invention may also contain dyes, plasticizers and additives for providing particular print-out characteristics. The photosensitive layer can be formed by coating a photosensitive composition dissolved in an appropriate solvent, on a support.

The amount of the above photosensitive layer coated on the support is preferably from 0.1 to 7 g/m², and especially from 0.5 to 3 g/m².

The thus obtained P.S. plate is exposed through a transparent original to an active light source such as a carbon arc light, mercury vapour lamp light, metal halide lamp light or tungsten lamp light and then developed by a wet developing process.

For the development of a P.S. plate having a diazo compound or o-quinonediazide compound as the photosensitive component thereof, a developing liquid with water as the principal solvent, containing an organic solvent, an alkaline agent, a surfactant, or an inorganic salt, for example, may be used, while for developing a P.S. plate having a photocrosslinkable or photopolymerizable photosensitive component, a developer prepared by dissolving a surfactant or alkaline agent for example, in a solvent which is principally organic may be used.

As the alkaline agent for use in the developing liquid whose principal solvent is water there may be advantageously used an inorganic alkaline agent such as sodium silicate, potassium silicate, potassium hydroxide, sodium hydroxide, lithium hydroxide, trisodium phosphate, sodium hydrogen carbonate, potassium carbonate or ammonium carbonate or an organic alkaline agent such as mono-, di- or tri-ethanolamine or propanolamine.

Suitable organic solvents which can be present in the developing liquid whose principal solvent is water include benzyl alcohol and n-propyl alcohol, while anionic, nonionic, or amphoteric surfactants can be used in such aqueous developers.

When the developing liquid is principally organic solvent, α-butylolactone or phenyl cellosolve (ethylene glycol monophenyl ether) are useful. These developing liquids desirably contain a defoaming agent or a wetting agent, for example.

The specified wet process step following development in the process of the present invention includes a stopping-development process step, a desensitizing process step, a stopping development process step with a successive desensitizing process step, or a stopping-desensitizing process step carried out with a single processing composition. Examples of such processes are described in, for example, Japanese Patent O.P.I. Publication No. 8002/1979 and No. 115045/1980.

In the method of the present invention, the process subsequent to the developing process desirably includes either a stopping process or a desensitizing process; further it is particularly desirable that the process immediately following the development is a stopping process which is followed by a desensitizing process.

The stopping process includes processing with a liquid containing a developer-neutralizing component such as an inorganic acid (e.g., phosphoric acid or sulphuric acid) or an organic acid (e.g., citric acid or succinic acid); processing with a liquid containing a component that inactivates the photosensitive

3

component, resin, etc., contained in the developing liquid, for example a liquid containing a known surfactant; and processing to lower the developing ability by diluting the developing liquid with a relatively large quantity of solvent (such as water). Of these procedures, a process that uses water, an inexpensive solvent, as the processing liquid to dilute the developing liquid is preferably used.

The desensitizing process which can be used in the present invention following the above-mentioned stopping process includes processing with a liquid containing a water-soluble macromolecular compound having a desensitizing effect such as gum arabic or dextrin and processing with a liquid prepared as required, by adding to the above liquid an inorganic acid (e.g., phosphoric acid, sulphuric acid or nitric acid), an organic acid (e.g., citric acid, tannic acid, malic acid, lactic acid or succinic acid), an inorganic salt (e.g., sodium phosphate or nickel nitrate), an organic solvent (e.g., a petroleum hydrocarbon or plasticizer), an alkali-soluble resin (e.g., a novolak resin), a wetting agent (e.g., a glycerol or ethylene glycol), or an oleophilic material such as a fat or oil or one of various types of surfactants.

As the processing liquid for use in the above-mentioned desensitizing process, a liquid containing an oleophilic material such as rosin, denatured rosin, a novolak resin, or an organic carboxylic acid having from 5 to 25 carbon atoms is preferably used for the purpose of increasing the oleophilicity of the image area.

For the combined process of stopping and desensitization, there may be used a liquid prepared by dissolving a component having the above-described desensitizing effect in a solvent consisting principally of water.

Further, in the method of the present invention, to control the ratio of the amount of processing liquid used in the preceding process carried into the processing liquid used in circulation and that of the processing liquid used in circulation carried out into a subsequent process, there is preferably used at least one squeezing mechanism arranged upstream and downstream of the processing step using said processing liquid used in circulation. Said squeezing mechanism includes a pair of juxtaposed rollers or an air knife system; the use of juxtaposed rollers is more desirable in view of their simplicity.

The amount of the processing liquid to be carried in (over) from the preceding section can be controlled very well by providing such squeezing mechanisms, which enables one to prevent the occurrence of stain on the printing plate caused principally by processing liquid carried over, and to prevent the early deterioration of the properties of the processing liquid.

Means for controlling the amount of processing liquid carried over includes, e.g. when a pair of juxtaposed rollers are used, a change in the pressure to be applied to the rollers and a change of the roller material. As the roller material there may be used silicone rubber or ordinary rubber, for example.

The present invention will now be illustrated, merely by way of example, with reference to the accompanying drawing, in which:

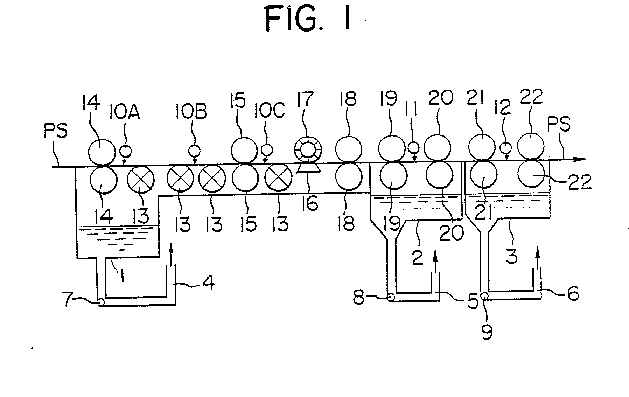

Figure 1 is a schematic diagram of an example of apparatus wherein the foregoing squeezing mechanisms are arranged in front and behind each of the processing sections following development, in the process in the present invention.

In the Figure 1, is a developing bath, 2 is a stopping bath i.e. one of the post-processing baths, and 3 is a desensitization bath. 4, 5 and 6 are solution pipe lines that transmit the processing liquid of baths 1, 2 and 3, respectively, to spray pipes described below. 7, 8 and 9 are pumps provided in said pipe lines, respectively. 10A, 10B and 10C are processing liquid spray pipes to spray onto the surface of a P.S. plate (PS) the processing liquid from bath 1. 11 and 12 are further spray pipes to spray onto the surface of the P.S. plate the liquid from bath 2 and bath 3, respectively (i.e. pipeline 5 supplies spray pipe 11 and pipeline 6 supplies spray pipe 12). 13 are guide rollers. 14 and 15 are transport rollers. 16 is a receiving tray and 17 is a brush roller. 18, 19, 20, 21 and 22 are squeeze rollers; for example, in stopping bath 2, squeeze rollers 19 located in front of and squeeze rollers 20 located behind spray pipe 11 of a P.S. plate are hereby designated as the "front" squeeze roller(s) and the "rear" squeeze roller(s), respectively. Similar comments apply to the squeeze rollers for desensitizing bath 3. PS is an exposed P.S. plate. The processing of a P.S. plate will now be outlined: PS is transported by transport rollers 14 to developing bath 1, guided by a series of guide rollers 13, and is developed by the developing liquid sprayed from spray pipes 10A, 10B and 10C. The developed surface of the P.S. plate is then brushed by brush roller 17 thereby to cause the hydrophilic surface thereof to appear completely, and then transported to the post-process steps. The excess developing liquid is squeezed out and transported by the squeeze rollers 18 to the stopping process step. The PS is first squeezed by front squeeze rollers 19 following squeeze rollers 18, and is then sprayed with liquid sprayed from spray pipe 11 to stop the development. The PS, after the stopping liquid thereon is squeezed out therefrom by rear squeeze rollers 20, is then transported to the subsequent desensitizing process. In this step also, the liquid of the preceding process is squeezed out first by front squeeze rollers 21; the PS is then subjected to the spray of a desensitizing liquid from spray pipe 12, and subsequently squeezed by rear squeeze rollers 22, and further transported. As will be understood, all the above-mentioned squeeze rollers can serve for the transportation of a P.S. plate. In the present invention, as regards the amount of liquid to be squeezed out by the above squeeze rollers, the following relationship is established:

The ratio of the amount ($S_2$) squeezed out by the rear squeeze rollers to the amount ($S_1$) squeezed out by the front squeeze rollers, since there is a loss by evaporation of the solvent contained in the liquid from the bath, need not necessarily be more than 1, but where P.S. plates are successively processed, the effect

4

becomes smaller, so that the ratio is desirably more than 1. If the amount squeezed out by the rear squeezed rollers is increased there is a greater influence upon subsequent processing, to that the ratio of the amounts $(S_2)$ to $(S_1)$ is desirably not more than 50, and more preferably not more than 30.

In the present invention, a particularly effective squeezing level is where the amount squeezed out is not more than 50 ml/m².

In the present invention, the reduction in the processing liquid caused by the above squeezing is replenished. The replenisher used in the present invention may be one that has the same composition as that of the processing liquid or one that differs from that composition and compensates for the deterioration in the original processing liquid. To carry out the replenishment the average difference between the amounts carried into and out of the bath is measured beforehand, and this average amount is replenished for each P.S. plate to be processed; alternatively, after processing a good round number of P.S. plates, say after every ten or twenty plates, replenishment is made to make up for the deficit.

The series of steps used especially in the present invention is such that the processing immediate after the development is a stopping process using a liquid whose solvent is water and the following step is a desensitization process step. When such a series of steps is used in the present invention, the stopping liquid and desensitizing liquid can be used continually over several months in contrast to the conventional way where both liquids have to be replaced every several days; in addition little or no waste fluid from the process after development is discharged, and further stable processing over a fairly extensive period of time can be performed.

The present invention is further illustrated in the following Examples:

Example 1

Three parts by weight of the esterified product of naphthoquinone-1,2-diazide-5-sulphonyl chloride with resorcinol-benzaldehyde resin (as described in Example 1 in Japanese Patent O.P.I. Publication No. 1044/1981), 9 parts by weight of cresol novolak resin, and 0.12 part by weight of Victoria Pure Blue BOH (dye manufactured by Hodogaya Chemical Co., Ltd.) were dissolved in 100 parts by weight of methyl cellosolve to prepare a coating liquid. A 0.3 mm-thick grained aluminium plate was anodized in sulphuric acid to thereby form an about 2.5 g/m² oxidized coat thereon and then washed sufficiently and dried. On this was coated and dried the above-prepared coating liquid, thus obtaining a presensitized lithographic printing plate having a photosensitive layer amounting to about 2.8 g/m². The thus obtained positive type P.S. plate was cut to 1003×800 mm size to prepare a number of plates. These prepared plates were exposed to a 2KW metal halide lamp light, through a transparent positive original, at a distance of 80 cm for 60 seconds.

Separately, an aqueous potassium silicate solution (26% by weight of $SiO_2$ and 13% by weight of $K_2O$), an aqueous potassium hydroxide solution (48% by weight) and pure water were used to prepare a developing solution wherein the ratio of $SiO_2/K_2O$ was 1.78 and the $K_2O$ content was 3.90% by weight, and a replenisher wherein the ratio of $SiO_2/K_2O$ was 0.88 and the $K_2O$ content was 7.79% by weight.

15 litres of water were put in a bath subsequent to the development bath as a stopping bath of an automatic processor as shown in Figure 1 (a modification of PSA-1315R automatic processor, manufactured by Konishiroku Photo Industry Co., Ltd., the washing section of which is modified so that the development bath is followed by two baths in which processing liquids may be used in circulation), the subsequent desensitizing bath was filled with 8 litres of a desensitizing liquid having the following composition:

| | |
|---|---|
| Gum arabic | 5.0 g |
| Dextrin | 15.0 g |
| Phosphoric acid (75%) | 0.3 g |
| Water | 80.0 g |
| Sodium di-2-ethyl-hexyl sulpho succinate | 1.0 g |
| Nonyl-phenol polyethyleneoxide ether (ethyleneoxide 6 mol) | 1.0 g |
| Stearic acid | 1.0 g |
| Sorbitane monooleate | 1.0 g |
| Dibutyl phthalate | 2.0 g |

The pressure of the respective rollers was adjusted so that the developing solution which could be carried into the stopping bath could be 4 ml/m², the water amount to be carried into the desensitizing bath could be 8 ml/m², and the desensitizing liquid carried out of the desensitizing bath could be 15 ml/m².

5

The foregoing developing solution was then put into the development bath, the P.S. plates were processed at the rate of 10 plates per hour, and the replenisher was added to replenish the development bath by 21 ml each time a P.S. plate was processed. When the processing operation was to be resumed after a long interval, the replenisher was initially added at the rate of 35 ml per hour. Each time a P.S. plate was processed, the washing bath was replenished with 6 ml of water, while the desensitizing bath was replenished with 8 ml of the foregoing desensitizing liquid. The P.S. plates were processed in the above manner, and no stain was observed in the prints obtained using the plate obtained even when 2,500 plates had been processed, and these satisfactory plates were obtained without producing any waste fluid from the baths.

The pressure of the respective squeeze rollers was readjusted so that the amount of developing solution carried into the stopping bath was 4 ml/m², the amount of water carried into the desensitizing bath was 4 ml/m², and the amount of liquid carried out of the desensitizing bath was 4 ml/m²; the printing plates were then processed by said automatic processor in the same manner as above except that no replenishment was made. An occurrence of stains was observed in non-image areas in the prints prepared from the plate obtained after 300 P.S. plates had been processed, so that the liquid had to be replaced.

Example 2

A 0.3 mm-thick grained aluminium plate was anodized in sulphuric acid to thereby form an about 2 g/m² oxidized coat thereon and then washed sufficiently. It was then immersed in an aqueous sodium silicate solution, washed sufficiently and then dried; the plate was coated with the following photosensitive liquid:

| | |
|---|---|
| p-hydroxyphenyl-methacrylamide-acrylonitrile-ethyl acrylate-methacrylic acid copolymer (molar ratio 12:35:42:11) | 5.0 g |
| Hexafluorophosphate of the condensate of p-diazodiphenyl-amine with paraformaldehyde | 0.5 g |
| Victoria Pure Blue-BOH (manufactured by Hodogaya Chemical Co., Ltd.) | 0.1 g |
| Methyl Cellosolve | 100.0 g |

The coated amount after drying was 1.8 g/m².

The thus obtained negative type P.S. plate was cut to 1003×800 mm sizes to prepare a number of P.S. plates, which were then exposed to a 2 KW metal halide lamp light through a transparent negative original at a distance of 80 cm for 50 seconds. Separately, 48 litres of a developing solution having the following composition was put in the development bath of an automatic processor similar to that used in Example 1.

Developer composition:

| | |
|---|---|
| Benzyl alcohol | 65 parts by wt. |
| Sodium carbonate, monohydrated | 11 parts by wt. |
| Sodium sulphite | 9 parts by wt. |
| 3-methyl-1,3-methoxybutanol | 250 parts by wt. |
| Water | 1,600 parts by wt. |

A desensitizing liquid (8 litres) similar to that used in Example 1 was put in the bath immediately following the development stop bath. The pressure of the squeeze rollers was adjusted so that the amount of developing solution to be carried into the desensitizing bath could be 4 ml/m², the amount of desensitizing composition to be carried out of the desensitizing bath could be 15 ml/m². The squeeze rollers at the bath next to the gum coating bath were removed to allow for transport alone. The foregoing P.S. plates were developed at the rate of 10 plates per hour, and the solutions were replaced by a new solution every 500-plates processed. The desensitizing bath was replenished with 12 ml of replenisher each time a plate was processed.

The P.S. plates were subjected to the above processing, and no stain or the like was observed even in the prints of plates obtained after processing 2,500 plates; satisfactory P.S. plates were obtained without producing any waste fluid from the respective baths.

The pressure of the squeeze rollers was readjusted so that the amount of developing solution to be carried into the gum coating bath could be 4 ml/m² and the amount of desensitizing liquid to be carried out of the desensitizing bath could be 4 ml/m². The P.S. plates were processed in the automatic processor in the same manner as above except that no replenishment was made; when 400 plates had been processed, and

6

subsequently, the ink respectively had deteriorated and scomming phenomena were observed in the non-image areas, so that the processing liquids needed to be replaced.

Example 3

A stopping liquid (8 litres) having the following compositions was put in the bath next to the development bath of an automatic processor similar to that used in Example 1.

Stopping development composition:

| Sodium di-(2-ethyl-hexyl) sulphosuccinate | 2.5 parts by wt. |
|---|---|
| Aqueous disodium hydrogen-phosphate-citric acid solution (pH 5 buffer solution) | 100 parts by wt. |

Subsequently, the pressure of the aqueous rollers was adjusted so that the amount of developing solution to be carried into the stopping bath could be 3 ml/m$^2$ and the amount of processing composition to be carried out of this bath could be 20 ml/m$^2$. The squeeze rollers at the subsequent bath were removed so that the transport alone could be made. The P.S. plate developing solution and the developer replenisher similar to those used in Example 1 were used to process the P.S. plates in the same manner as in Example 1; the stopping bath was replenished with 18 ml of the above-described liquid each time a P.S. plate was processed. The processed plate was coated thereon with a desensitizing agent and then transferred to a printing process. No stain was observed even in the prints prepared from a plate obtained after 2,000 plates had been processed; thus satisfactory P.S. plates were obtained without producing any waste fluid from the baths.

The pressure of the squeeze rollers was readjusted so that the amount of developing solution to be carried into the stopping bath could be 3 ml/m$^2$ and the amount of stopping liquid to be carried out of the stopping bath could be 3 ml/m$^2$. The P.S. plates were processed in like manner as above in the automatic processor without any replenishment; scomming phenomena were observed in the non-image areas when 200 plates had been processed, so that the replacement of the processing solutions was necessary; when 2,000 plates had been processed, about 70 litres of waste stopping liquid had been produced.

## Claims

1. A method of processing an exposed photosensitive lithographic printing plate by processing in at least one wet process step following development of an exposed photosensitive lithographic printing plate, the processing liquid used in said at least one wet process step being used in circulation characterised in that the amount of processing liquid in the preceding step carried into the processing liquid in said wet process step being less than the amount of the processing liquid in said wet process step carried out therefrom, the shortfall in the processing liquid used in said wet process step being replenished.

2. A method according to claim 1, wherein the plate passes through squeezing mechanisms upstream and downstream of said wet process step.

3. A method according to claim 2, wherein the amount of the processing liquid in the preceding process carried into the processing liquid of said wet process step through said squeezing mechanism upstream of said wet process step is less than that of the processing liquid used carried out therefrom through said squeezing mechanism downstream of said wet process step.

4. A method according to any one of claims 1 to 3, wherein the ratio of the amount of the processing liquid of said wet process step carried out therefrom to the amount of the processing liquid in the preceding process carried into said step is not more than 50:1.

5. A method according to claim 4 wherein said ratio is not more than 30:1.

6. A method according to any one of the preceding claims, wherein said wet process step is a step of stopping development or a desensitizing step.

7. A method according to claim 6, wherein the processing liquid used in said stopping development step is water.

8. A method according to claim 6, wherein the processing liquid used in said desensitizing step comprises an oleophilic material.

9. A method according to any one of claims 6 to 8, wherein said desensitizing step is subsequent to said stopping development step.

## Patentansprüche

1. Verfahren zur Behandlung einer belichteten lichtempfindlichen lithografischen Druckplatte in mindestens einem Naßverfahrensschritt mit nachfolgender Entwicklung der belichteten lichtempfindlichen lithografischen Druckplatte, wobei die in dem mindestens einen Naßverfahrensschritt verwendete Behandlungsflüssigkeit zirkulierend verwendet wird, dadurch gekennzeichnet, daß die Menge der Behandlungsflüssigkeit, die im vorhergehenden Verfahrensschritt in die Behandlungsflüssigkeit dieses Naßverfahrensschrittes eingebracht wird, kleiner ist als die Menge der Behandlungsflüssigkeit, die in diesem Naßverfahrensschritt entfernt wird, und daß der Fehlbestand der in diesem Naßverfahrensschritt verwendeten Behandlungsflüssigkeit nachgefüllt wird.

2. Verfahren nach Anspruch 1, dadurch gekennzeichnet, daß die Platte durch stromaufwärts und stromabwärts des Naßverfahrensschrittes vorgesehene Preßvorrichtungen durchbewegt wird.

3. Verfahren nach Anspruch 2, dadurch gekennzeichnet, daß die Menge der Behandlungsflüssigkeit, die im vorhergehenden Verfahren in die Behandlungsflüssigkeit des Naßverfahrensschrittes durch die stromaufwärts des Naßverfahrensschrittes vorgesehene Preßvorrichtung eingebracht wird, kleiner ist als die Menge der verwendeten Behandlungsflüssigkeit, die durch die stromabwärts des Naßverfahrensschrittes vorgesehene Preßvorrichtung entfernt wird.

4. Verfahren nach einem der Ansprüche 1 bis 3, dadurch gekennzeichnet, daß das Verhältnis der Menge der aus dem Naßverfahrensschritt entfernten Behandlungsflüssigkeit zu der Menge der im vorhergehenden Verfahren in diesen Verfahrensschritt eingebrachten Behandlungsflüssigkeit nicht größer als 50:1 ist.

5. Verfahren nach Anspruch 4, dadurch gekennzeichnet, daß das Verhältnis nicht größer als 30:1 ist.

6. Verfahren nach einem der vorhergehenden Ansprüche, dadurch gekennzeichnet, daß der Naßverfahrensschritt ein die Entwicklung stoppender Schritt oder ein Desensiblisierungsschritt ist.

7. Verfahren nach Anspruch 6, dadurch gekennzeichnet, daß die im die Entwicklung stoppenden Schritt verwendete Behandlungsflüssigkeit Wasser ist.

8. Verfahren nach Anspruch 6, dadurch gekennzeichnet, daß die im Desensibilisierungsschritt verwendete Behandlungsflüssigkeit ein oleophiles (-oleophilic) Material enthält.

9. Verfahren nach einem der Ansprüche 6 bis 8, dadurch gekennzeichnet, daß der Desensibilisierungsschritt dem die Entwicklung stoppenden Schritt nachfolgt.

## Revendications

1. Procédé de traitement d'une plaque d'impression lithographique photosensible exposée, dans lequel on traite dans au moins une étape de procédé au mouillé une plaque d'impression lithographique photosensible exposée après son développement, le liquide de traitement utilisé dans au moins ladite étape de procédé au mouillé étant recyclé, caractérisé en ce que la quantité de liquide de traitement de l'étape précédente transporté dans le liquide de traitement dans ladite étape de procédé au mouillé est inférieure à la quantité de liquide de traitement dans ladite étape de procédé au mouillé emporté hors de celui-ci, la quantité manquante du liquide de traitement utilisé dans ladite étape de procédé au mouillé étant remplacée.

2. Procédé selon la revendication 1, caractérisé en ce que la plaque traverse des mécanismes d'exprimage en amont et en aval de ladite étape de procédé au mouillé.

3. Procédé selon la revendication 2, caractérisé en ce que la quantité du liquide de traitement dans le procédé précédent emporté dans le liquide de traitement de ladite étape de procédé au mouillé à travers ledit mécanisme d'exprimage en amont de ladite étape de procédé au mouillé est inférieure à celle du liquide de traitement utilisé emporté hors de celui-ci à travers ledit mécanisme d'exprimage en aval de ladite étape de procédé au mouillé.

4. Procédé selon l'une quelconque des revendications précédentes, caractérisé en ce que le rapport de la quantité de liquide de traitement de ladite étape de procédé au mouillé emporté de celui-ci à la quantité de liquide de traitement dans le procédé précédent transporté dans ladite étape n'est pas supérieure à 50:1.

5. Procédé selon la revendication 4, caractérisé en ce que ledit rapport n'est pas supérieur à 30:1.

6. Procédé selon l'une quelconque des revendications précédentes, caractérisé en ce que ladite étape de procédé au mouillé est une étape d'arrêt du développement ou une étape de désensibilisation.

7. Procédé selon la revendication 6, caractérisé en ce que le liquide de traitement utilisé dans ladite étape d'arrêt du développement est l'eau.

8. Procédé selon la revendication 6, caractérisé en ce que le liquide de traitement utilisée dans ladite étape de désensibilisation comprend une matière oléophile.

9. Procédé selon l'une quelconque des revendications 6 à 8, caractérisé en ce que ladite étape de désensibilisation est postérieure à ladite étape d'arrêt du developpement.

# FIG. I